# FASCICULE DE BREVET EUROPEEN

(11) **EP 0 708 525 B1**
(45) Date de publication et mention de la délivrance du brevet: **21.01.1998**
(21) Numéro de dépôt: 95202722.5
(22) Date de dépôt: 10.10.1995
(51) Int. Cl.: H03F 3/217, H03F 3/30

(54) **Etage amplificateur de puissance délivrant un signal rectangulaire d'amplitude controlée**
Ein Rechtecksignal liefernde Leistungsverstärkerstufe mit gesteuerter Amplitude
Power amplifier stage delivering a square wave signal with regulated amplitude

(30) Priorité: 19.10.1994 FR 9412489
(43) Date de publication de la demande: 24.04.1996
(73) Titulaire: PHILIPS COMPOSANTS ET SEMICONDUCTEURS, 92150 Suresnes (FR); PHILIPS ELECTRONICS N.V., 5621 BA Eindhoven (NL)
(72) Inventeur: Bailly, Patrick, F-75008 Paris (FR)
(74) Mandataire: Charpail, François

(56) Documents cités:
- EP-A- 0 578 098
- EP-A- 0 587 945
- GB-A- 2 070 371

## Description

La présente invention telle qu'elle est définie dans les revendications concerne un étage amplificateur de puissance délivrant un signal rectangulaire sur une charge au moyen d'un amplificateur du type dit "en pont" à deux paires de transistors bipolaires du même type de conductivité, une première paire de transistors dont les émetteurs sont respectivement connectés aux bornes de la charge ainsi que respectivement aux collecteurs des transistors de la deuxième paire de transistors, une pluralité de dispositifs interrupteurs appliquant alternativement une tension de commande d'amplitude sur les bases respectives des transistors de la première paire et modifiant en synchronisme la polarisation de base des transistors de la deuxième paire.

Un étage de puissance de ce genre est connu du document EP-A-0 587 945. Selon ce document, un signal de type rectangulaire est créé aux bornes d'une charge au moyen de huit interrupteurs dont quatre sont actionnés en phase et quatre actionnés en phase inversée. L'amplitude du signal obtenu sur la charge est régulée en faisant appel à la commutation d'une capacité qui est, au moyen de deux commutateurs, alternativement connectée aux bornes de la charge puis connectée à l'entrée d'un amplificateur à contre-réaction pour comparaison avec une tension de référence.

Le document GB-A-2 070 371 divulgue également un exemple d'étage de sortie "en pont".

L'étage amplificateur connu a été conçu pour alimenter une charge dont l'impédance est résistive et éventuellement selfique et pour éviter une instabilité liée à la contre-réaction de l'amplificateur et aux capacités parasites du circuit. Il est mal adapté a commander une charge dont l'impédance serait principalement capacitive comme c'est le cas d'un transducteur piézo-électrique générateur de signal sonore. Du fait qu'une charge de ce genre n'est pas traversée par un courant continu, le signal de tension qui serait obtenu en utilisant l'étage amplificateur connu serait très déformé avec une perte notable des harmoniques du signal. Or la création d'harmoniques élevées est au contraire recherchée pour augmenter l'efficacité acoustique de ce genre de transducteur, notamment lorsqu'il s'agit de signaux avertisseurs, par exemple dans un appareil téléphonique.

Par ailleurs, l'étage amplificateur connu du document cité se révèle relativement compliqué notamment en ce qui concerne le nombre élevé d'interrupteurs utilisés pour créer le signal d'impulsions rectangulaires sur la charge.

L'invention a pour but de fournir un étage amplificateur de puissance de structure simple et donc intégrable de manière économique, qui soit adapté à piloter une charge à dominante capacitive telle qu'un transducteur piézo-électrique. Un autre but de l'invention est de fournir un étage amplificateur de puissance apte à constituer une fonction de sonnerie parmi d'autres fonctions réalisées par un circuit intégré destiné à une application aux récepteurs téléphoniques, sonnerie dont le niveau sonore pourrait être ajusté à volonté par l'utilisateur, y compris à un niveau faible, sans altération du timbre de la sonnerie.

L'invention se base notamment sur l'idée qu'un signal de commutation rectangulaire sera correctement appliqué sur une charge capacitive si les tensions appliquées aux extrémités de la charge sont générées sous une impédance suffisamment faible en courant continu.

Ainsi, l'étage amplificateur de puissance du type énoncé dans le paragraphe introductif, est caractérisé selon la présente invention, en ce que les bases des quatre transistors de l'amplificateur sont reliées respectivement à quatre sources de courant débitant des courants sensiblement égaux et en ce que les transistors de la deuxième paire sont alternativement connectés en diodes au moyen de deux des dispositifs interrupteurs.

L'invention ne nécessite que quatre dispositifs interrupteurs pour la commande de l'amplificateur en pont, au lieu de huit interrupteurs utilisés dans l'étage amplificateur de l'art antérieur, pour la seule commande de l'amplificateur en pont.

Du fait qu'un courant de base est maintenu en permanence dans chacun des quatre transistors de l'amplificateur, les extrémités de la charge sont soumises à tout instant à une tension qui est générée sous une impédance dont la valeur maximale en courant continu est fixée. Cette valeur peut être aisément adaptée à la capacité nominale d'une charge donnée, par un choix approprié du courant fourni par les sources de courant de base, courant qui assure un temps de montée du signal de valeur fixée.

L'étage amplificateur selon l'invention évite l'emploi d'une contre-réaction ainsi que les problèmes d'instabilité qui y sont associés lorsque la charge utilisée est à dominante capacitive. Néanmoins, cet étage amplificateur permet une commutation rapide de la tension du signal de sortie et assure un contrôle précis de l'amplitude de ce signal, même à un niveau faible, de l'ordre du 1/10^{e} de volt crête.

Les caractéristiques de fonctionnement de l'étage amplificateur de puissance selon l'invention peuvent être rendues pratiquement indépendantes des fluctuations du gain des transistors (variations dues au procédé de fabrication) ainsi qu'aux variations de la température dans un mode de réalisation de l'invention caractérisé en ce que les sources de courant alimentant les bases sont réalisées au moyen d'un miroir de courant comportant quatre sorties appairées entre elles et une entrée alimentée par le courant de base d'un cinquième transistor, de même type de conductivité que celui des quatre premiers transistors, lequel transistor a son émetteur alimenté par une source de courant de référence. De cette manière, les quatre courants de base générés sont comparés au courant de base du cinquième transistor lequel a son courant d'émetteur fixé par une source de référence stable. Les courants d'émetteur des quatre transistors formant l'amplificateur en pont sont donc rendus sensiblement identiques au courant du cinquième transistor, ou encore, à un multiple de ce courant selon que le miroir de courant a un rapport de courant de sortie sur courant d'entrée égal ou plus grand que l'unité.

Dans une application où la charge émet un signal sonore, comme une sonnerie d'un téléphone, application dans laquelle il est désirable de pouvoir régler le volume sonore dans une large plage de valeurs, l'invention prévoit avantageusement que la tension de commande d'amplitude est issue d'un générateur de tension comportant un convertisseur numérique-analogique pour la conversion de signaux numériques de commande appliqués en entrée de ce générateur.

La description qui va suivre en regard des dessins annexés, donnés à titre d'exemples non limitatifs, fera bien comprendre en quoi consiste l'invention et comment elle peut être réalisée.

La figure 1 montre le schéma électrique d'un étage amplificateur de puissance conforme à l'invention.

La figure 2 montre l'allure des signaux de sortie du circuit de la figure 1 pour plusieurs valeurs de polarisation continue des transistors.

La figure 3 montre le schéma de réalisation préférée d'un générateur de courants de base, à quatre sorties, à utiliser dans l'étage amplificateur selon l'invention.

La figure 4 indique le schéma d'un générateur de tension de commande d'amplitude adapté à la commande de l'étage amplificateur de la figure 1.

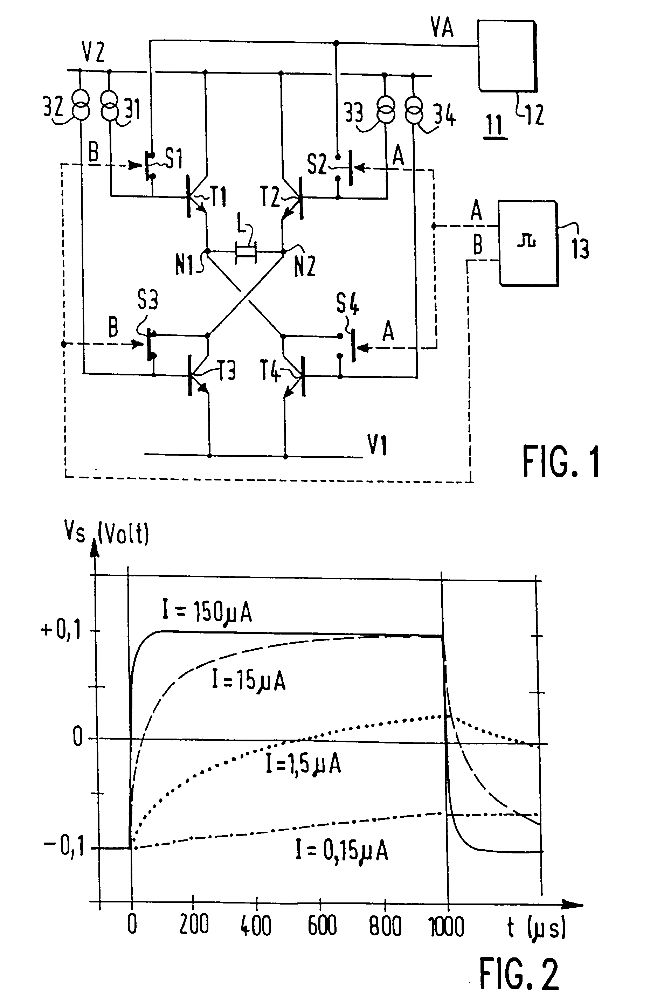

A la figure 1, un étage amplificateur de puissance conforme à l'invention est représenté. Il comporte un amplificateur du type "en pont" muni de deux paires de transistors bipolaires de type NPN, une première paire de transistors T1, T2 dont les émetteurs sont respectivement connectés aux extrémités d'une charge L ainsi qu'aux collecteurs d'une deuxième paire de transistors T3, T4 dont les émetteurs sont reliés à une borne d'alimentation V1 servant de référence de tension. Les collecteurs des deux transistors de la première paire T1, T2 sont connectés à une tension d'alimentation positive V2. Un générateur de tension 12 fournit une tension de commande VA qui est ajustable et est appliquée aux bases des transistors T1 et T2, alternativement, au moyen de deux dispositifs interrupteurs S1, S2. Les transistors T3 et T4 de la deuxième paire de transistors sont connectés en diodes alternativement au moyen de deux dispositifs interrupteurs S3, S4. Les dispositifs interrupteurs S1 à S4 sont commandés par un générateur de signaux de commutation 13 lequel détermine la fréquence et le rapport cyclique des signaux rectangulaires à fournir sur la charge L. Il est agencé de telle sorte que les dispositifs interrupteurs S1 et S3 soient fermés simultanément tandis que les dispositifs interrupteurs S2 et S4 sont actionnés en opposition de phase. Les dispositifs interrupteurs peuvent être constitués par des transistors à effet de champ de type MOS.

Les quatre transistors T1-T4 de l'amplificateur en pont ont chacun leur base connectée respectivement à quatre sources de courant 31-34, ces sources de courant débitant un courant essentiellement identique, à partir de la tension d'alimentation V2. Cette disposition est particulièrement bien adaptée pour actionner une charge L dont l'impédance est essentiellement capacitive comme c'est le cas d'un transducteur piézo-électrique.

Sur la figure, la position des dispositifs interrupteurs correspondant à l'un des deux états possibles d'un signal rectangulaire a été représentée.

Dans cet état, le générateur 13 fournit un signal A déterminant l'ouverture des dispositifs interrupteurs S2 et S4 et fournit un signal B qui est l'inverse du signal A déterminant la fermeture des dispositifs interrupteurs S1 et S3. La tension de commande d'amplitude VA est appliquée sur la base du transistor T1 qui se comporte comme émetteur-suiveur et fournit à une borne N1 de la charge L, cette tension, diminuée d'une chute de tension émetteur-base. Le transistor T4 dont le collecteur est connecté à la même borne N1 de la charge L absorbe un courant égal à β fois le courant fourni par la source de courant de base 34, (β étant la valeur du gain en courant des transistors).

Ce courant absorbé sur l'émetteur du transistor T1 fixe une limite pour la valeur de la chute de tension émetteur-base (V_{BE}) du transistor T1 en dehors de la période transitoire correspondant à la commutation du signal. En l'absence d'un tel courant, la valeur du V_{BE} continuerait à décroître , de plus en plus lentement au cours du temps.

Le transistor T3, connecté en diode constitue une impédance faible pour la transmission de courants transitoires depuis la borne N2 de la charge L jusqu'à la ligne d'alimentation V1, tandis qu'une limite maximale de cette impédance est fixée par le courant émetteur du transistor T2, courant qui est égal à (β+1) fois le courant de la source de courant 33 alimentant la base de ce transistor.

Il est clair que pour l'autre alternance du signal, la disposition d'ouverture et de fermeture des dispositifs interrupteurs est opposée à celle qui vient d'être décrite.

Au moment de la commutation, d'une alternance à l'autre, pour le signal appliqué sur la charge L, un courant transitoire important traverse cette charge du fait que la capacité de la charge était polarisée de manière inversée juste avant la transition.

Durant la période transitoire qui se produit alors, on peut observer que la tension émetteur-base du transistor de la première paire fonctionnant en émetteur-suiveur décroît au cours du temps puisque le courant traversant la charge L décroît lui-même. Dans le transistor qui referme le circuit à ce moment là, en étant connecté en diode, la chute de tension décroît au cours du temps puisque le courant qui traverse cette diode décroît. Les valeurs limites de ces deux V_{BE} sont fixées par le courant continu débité par les transistors sous l'effet des sources de courant de base 31 à 34. Le temps d'établissement des paliers d'amplitudes du signal rectangulaire à générer sur la charge L peut donc être réglé à la valeur désirée par le choix de la valeur de courant continu débité par les transistors.

La figure 2 représente l'allure de signaux de sortie de l'étage amplificateur de la figure 1, pour différentes valeurs de courant continu traversant les transistors T1 à T4, au cours du temps t. La charge L présente une capacité de 80nF.

Sur cette figure, la tension Vs aux bornes de la charge L est observée pour une tension crête de 0,1 Volt. Le paramètre I indiqué est la valeur du courant continu appliqué aux transistors T1-T4, c'est-à-dire β fois le courant des sources de courant 31-34.

Il est clair que pour une amplitude aussi faible que 0,1 Volt, la forme du signal obtenu est très variable en fonction du courant I choisi, et elle se rapproche d'autant plus d'un signal rectangulaire que le courant I est plus important. Une valeur de courant de l'ordre de 150µA apparaît suffisante et bien adaptée à la production d'un signal sonore sur un transducteur de ce type.

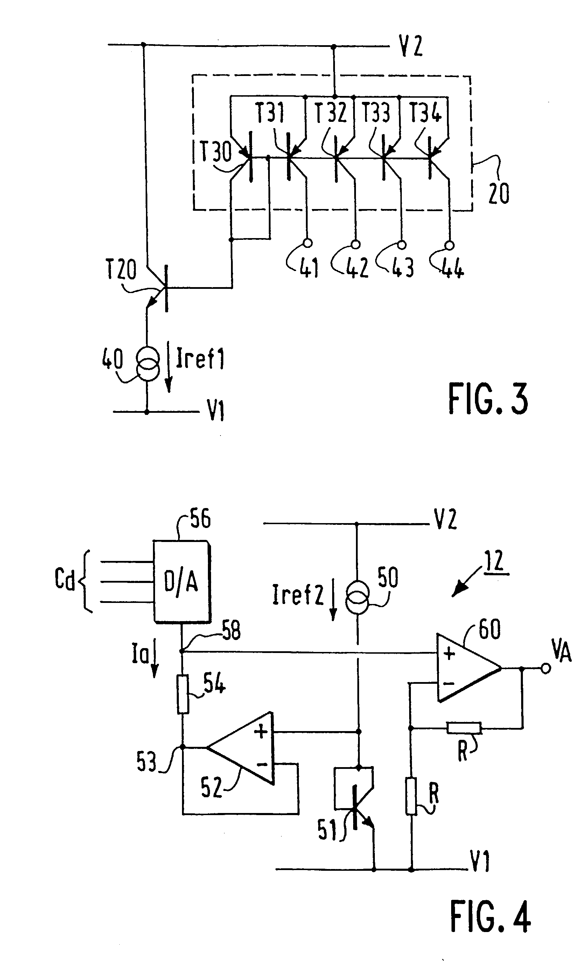

La figure 3 indique le schéma d'un générateur de courant de base particulièrement adapté à la réalisation des sources de courant 31 à 34 de la figure 1. Ce générateur comporte un miroir de courant 20 composé de cinq transistors de type PNP, un transistor d'entrée T30 et quatre transistors de sortie T31 à T34. Les transistors T31 à T34 sont appairés entre eux de sorte que les courants délivrés par leur collecteur respectif 41 à 44 sont des courants égaux entre eux. Une autre condition pour obtenir des performances reproductibles en fonction de variations possibles du processus de fabrication et en fonction des variations de la température d'utilisation consiste à alimenter le transistor d'entrée T30 du miroir de courant 20 avec le courant de base d'un transistor NPN T20 dont l'émetteur est alimenté par un courant de référence Iref1 fourni par une source de courant de référence 40. Le courant de référence Iref1 peut être rendu indépendant de la température par des moyens bien connus des spécialistes. Si dans le procédé de réalisation de l'étage amplificateur selon l'invention, des variations de gain des transistors NPN se produisent, le courant débité par les transistors T1 à T4 de l'amplificateur en pont sera néanmoins assujetti à être égal au courant débité par le transistor T20. On peut également prévoir de réaliser le miroir de courant 20 avec un rapport de courant de sortie/courant d'entrée différent de l'unité et en particulier un courant de sortie plus élevé que le courant d'entrée. Une réduction de consommation de courant est ainsi réalisée par une réduction du courant débité par le transistor T20. Dans ce cas, les courants débités par les transistors T31 et T34 seront proportionnels au courant de base du courant T20 et les courants émetteur/collecteur des transistors T1 à T4 seront eux-mêmes proportionnels au courant de référence Iref1.

En ce qui concerne l'amplitude du signal produit sur la charge L, il est aisé de voir que cette amplitude est liée à la tension VA fournie par le générateur de tension 12 (figure 1) diminuée de deux chutes de tension dans une diode polarisée en direct. Il est donc avantageux de prévoir que le générateur de tensions de commandes d'amplitudes fournisse une tension VA dont la valeur comporte une partie fixe égale à 2.V_{BE} et une partie qui varie selon la loi de variation que l'on désire. Lorsque la charge L est un transducteur piézo-électrique pour la production d'un signal sonore, il est souhaitable que la progression de cette partie variable de la tension de commande soit plus rapide qu'une variation linéaire, de manière à se rapprocher de la sensibilité de l'oreille humaine et par exemple, que la partie variable varie selon une progression géométrique.

La figure 4 présente le schéma d'un exemple de générateur de tension de commande d'amplitude. Le générateur 12 comporte une source de courant de référence 50 débitant à partir de la tension d'alimentation positive V2 un courant de référence Iref2 dans un transistor 51 connecté en diode et dont l'émetteur est relié à la tension d'alimentation de référence V1. La chute de tension de la diode 51 sous l'effet du courant Iref2 est appliquée à l'entrée d'un amplificateur 52 de gain unité dont la sortie 53 présente la même tension que la tension d'entrée mais sous une impédance faible.

Le générateur 12 comporte en outre un convertisseur numérique-analogique 56 destiné à la conversion de signaux numériques d'entrée Cd en un courant analogique Ia alimentant une résistance 54 par une extrémité 58 l'autre extrémité étant connectée à la sortie 53 de l'amplificateur 52.

A titre d'exemple, si les signaux d'entrée Cd sont fournis sous un format de 3bits, le convertisseur 56 peut être agencé pour fournir huit valeurs de courant Ia étagées entre 1µA et 128µA, les valeurs se succédant entre elles selon un facteur 2. L'extrémité 58 de la résistance 54 présente donc une tension qui d'une part est proportionnelle au courant Ia représentant la partie variable de la commande de tension augmentée d'une chute de tension fixe dans la diode 51. Cette extrémité 58 est reliée à l'entrée d'un autre amplificateur 60 dont le gain en tension est réglé à 2 au moyen d'une contre réaction de deux résistances égales notées R sur la figure 3. Cet amplificateur 60 fournit en sortie la tension VA qui sera utilisée pour commander l'amplitude du signal délivré par l'amplificateur en pont.

Le signal de commande VA comporte donc une partie fixe correspondant au double de la chute de tension dans le transistor 51 et il permet ainsi d'obtenir sur la charge L une amplitude égale à la partie variable du signal de commande VA.

Une compensation précise des V_{BE} est obtenue lorsque le courant Iref2 de la source de courant de référence 50 est en relation convenable avec le courant Iref1 de la source de courant 40 représenté à la figure 3 compte tenu des rapports de surface des transistors mis en jeu, aussi bien dans le miroir de courant 20 (figure 3) que dans l'amplificateur en pont représenté à la figure 1.

## Revendications

1. Etage amplificateur de puissance délivrant un signal rectangulaire sur une charge au moyen d'un amplificateur du type dit "en pont" à deux paires de transistors bipolaires du même type de conductivité, une première paire de transistors dont les émetteurs sont respectivement connectés aux bornes de la charge ainsi que respectivement aux collecteurs des transistors de la deuxième paire de transistors, une pluralité de dispositifs interrupteurs appliquant alternativement une tension de commande d'amplitude sur les bases respectives des transistors de la première paire et modifiant en synchronisme la polarisation de base des transistors de la deuxième paire,
caractérisé en ce que les bases des quatre transistors de l'amplificateur sont reliées respectivement à quatre sources de courant débitant des courants sensiblement égaux et en ce que les transistors de la deuxième paire sont alternativement connectées en diodes au moyen de deux des dispositifs interrupteurs.

2. Etage amplificateur de puissance selon la revendication 1, caractérisé en ce que les sources de courant alimentant les bases sont réalisées au moyen d'un miroir de courant comportant quatre sorties appairées entre elles et une entrée alimentée par le courant de base d'un cinquième transistor, de même type de conductivité que celui des première et deuxième paires, lequel transistor a son émetteur alimenté par une source de courant de référence.

3. Etage amplificateur de puissance selon la revendication 2, caractérisé en ce que la tension de commande d'amplitude est issue d'un générateur de tension comportant un convertisseur numérique-analogique pour la conversion de signaux numériques de commande appliqués en entrée de ce générateur.

## Patentansprüche

1. Eine Leistungsverstärkerstufe, die ein Rechtecksignal auf eine mittlere Ladung eines "Brücken"-Verstärkertyps mit zwei bipolaren Transistorpaaren gleicher Leitfähigkeit abgibt, einen ersten Teil des Transistors, dessen Emitter jeweils an die Ladeklemmen sowie jeweils an die Kollektoren der Transistoren des zweiten Transistorpaars angeschlossen sind, eine Vielzahl an Unterbrechervorrichtungen, die abwechselnd eine Amplitudensteuerspannung auf die jeweiligen Basen der Transistoren des ersten Teils anwenden und synchron die Basispolarisierung der Transistoren des zweiten Teils ändern,
dadurch gekennzeichnet, daß die Basen der vier Transistoren des Verstärkers jeweils mit vier Stromquellen verbunden sind, die grundlegend gleiche Ströme abgeben, und daß die Transistoren des zweiten Paars dagegen unter Verwendung von zwei Unterbrechervorrichtungen als Dioden geschaltet sind.

2. Leistungsverstärkerstufe nach Anspruch 1, dadurch gekennzeichnet, daß diese die Basen versorgenden Stromquellen mit einem Stromspiegel mit vier untereinander gepaarten Ausgängen und einem Eingang hergestellt werden, der vom Basisstrom eines fünften Transistors versorgt wird und derselben Leitfähigkeit wie die der ersten und zweiten Paare ist, wobei der Emitter dieses Transistors von einer Referenzstromquelle versorgt wird.

3. Leistungsverstärkerstufe nach Anspruch 2, dadurch gekennzeichnet, daß die Amplitudensteuerspannung aus einem Spannungsgenerator herrührt, der einen Digital-Analog-Wandler für die Umwandlung der dem Eingang dieses Generators zugeführten digitalen Steuersignale aufweist.

## Claims

1. A power amplifier stage producing a rectangular signal across a load by means of a "bridge" type amplifier comprising two pairs of bipolar transistors of the same conductivity type, a first pair of transistors having their respective emitters connected to the terminals of the load and to the respective collectors of the transistors of the second pair of transistors, a plurality of switching devices alternately supplying an amplitude control voltage to the respective bases of the transistors of the first pair and synchronously changing the base bias of the transistors of the second pair,
characterized in that the bases of the four transistors of the amplifier are respectively coupled to four current sources supplying substantially equal currents and in that the transistors of the second pair are alternately connected as diodes by means of two of the switching devices.

2. A power amplifier stage as claimed in Claim 1,
characterized in that the current sources driving the bases are formed by means of a current mirror having four outputs which are paired with one another and having an input receiving the base current of a fifth transistor of the same conductivity type as those of the first and the second pair, the emitter of said fifth transistor being driven by a reference current source.

3. A power amplifier stage as claimed in Claim 2,
characterized in that the amplitude control voltage is obtained from a voltage generator comprising a digital-to-analog converter for the conversion of digital control signals applied to the input of this generator.
